# EUROPEAN PATENT APPLICATION

(11) **EP 4 517 810 A1**
(43) Date of publication of application: **05.03.2025**
(21) Application number: 23194541.1
(22) Date of filing: 31.08.2023
(51) Int. Cl.: H01L 23/31, H01L 23/433

(54) **SEMICONDUCTOR PACKAGE AND A METHOD OF MANUFACTURING A SEMICONDUCTOR PACKAGE**

(71) Applicant: Infineon Technologies Austria AG, 9500 Villach (AT)
(72) Inventor: SINGER, Frank, 93128 Regenstauf (DE); SCHARF, Thorsten, 93138 Lappersdorf, Kareth (DE)
(74) Representative: Infineon Patent Department

(57) **Abstract**

A semiconductor package comprises a substrate comprising a die pad and a semiconductor die mounted on the die pad of the substrate. The semiconductor package comprises an encapsulation encapsulating the semiconductor die and the substrate. The encapsulation comprises a recess at an outer surface of the encapsulation.

## Description

### TECHNICAL FIELD

The present invention relates to the cooling of semiconductor packages, in particular of high voltage semiconductor packages.

### BACKGROUND

A semiconductor package may comprise one or more semiconductor dies mounted on a substrate/die pad. An encapsulation, e.g., mold compound, encapsulates the semiconductor dies and the substrate. High switching speed and/or high currents lead to the generation of heat during operation. In order to provide sufficient cooling to the semiconductor dies parts of the substrate may be exposed from the encapsulation. A heat sink may be mounted on the encapsulation comprising the exposed substrate part, also referred as exposed pad via a thin layer of a thermal interface material that provides electrical isolation. In particular high voltage class products also need to fulfill creepage distance requirements while keeping the thermal characteristics at a high level. Exposed pads may thus not be desirable or even optional. Packages with heat transfer through mold compound are however limited in the ability to transfer thermal energy into the surrounding environment. Improved semiconductor packages and improved methods for manufacturing semiconductor packages may help to overcome these and other problems.

### SUMMARY

According to an example of the disclosure, a semiconductor package comprises a substrate and a semiconductor die mounted to a first surface of the substrate. The semiconductor package further comprises an encapsulation encapsulating the semiconductor die and the substrate. The encapsulation comprises a recess at an outer surface of the encapsulation. A material fills up the recess, wherein the material has a higher thermal conductivity than the encapsulation, wherein the material is electrically isolated from the substrate and the semiconductor die.

According to an example of the disclosure, a method for producing a semiconductor package, wherein the method comprises:
- providing a substrate,
- mounting a semiconductor die to a first surface of the substrate,
- encapsulating the semiconductor die and at least part of the substrate by an encapsulation,
- providing a recess at an outer surface of the encapsulation,
- disposing a material within the recess,
- wherein the material has a higher thermal conductivity than the encapsulation,
- wherein the material is electrically isolated from the substrate and the semiconductor die.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Figure 1 illustrates a cross-sectional view of a semiconductor package with recesses of uniform depth on one side of its encapsulation.
Figure 2 illustrates a cross-sectional view of a semiconductor package with recesses of varying depth on opposing sides of the encapsulation.
Figure 3 illustrates a cross-sectional view of an alternative example of a semiconductor package with recesses of varying depth on opposing sides of the encapsulation.
Figure 4A illustrates a cross-sectional view of a further exemplary embodiment of a semiconductor package.
Figure 4B and 4C illustrate alternative top views of the semiconductor package of Figure 4A.

### DETAILED DESCRIPTION

In the following description, directional terminology, such as "top", "bottom", "upper", "lower" "front", "back" etc., is used with reference to the orientation of figures being described. The components of the disclosure can be positioned in a number of different orientations, the directional terminology is used for purposes of illustration and is in no way limiting.

Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements co-operate or interact with each other regardless of whether they are in direct physical or electrical contact, or they are not in direct contact with each other; intervening elements or layers may be provided between the "bonded", "attached", or "connected" elements.

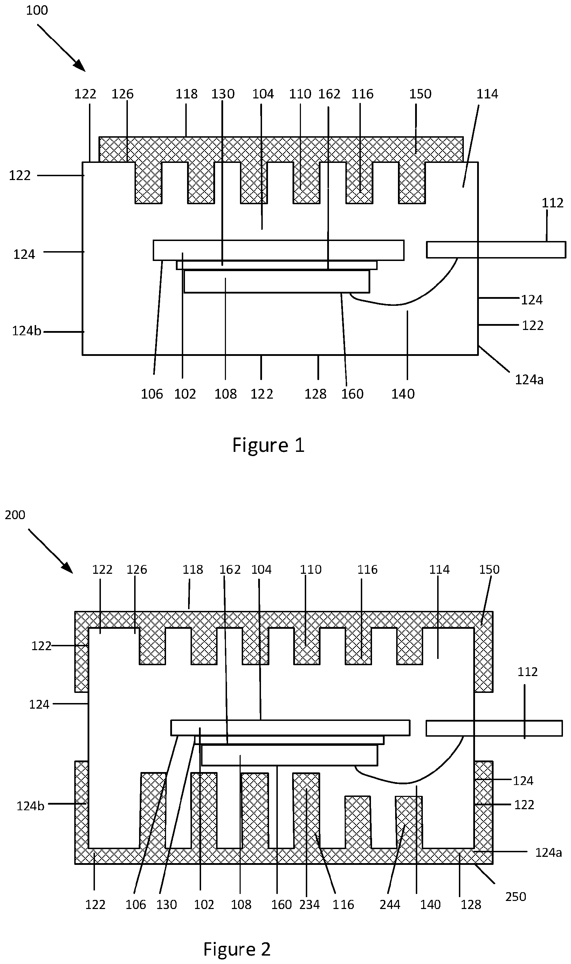

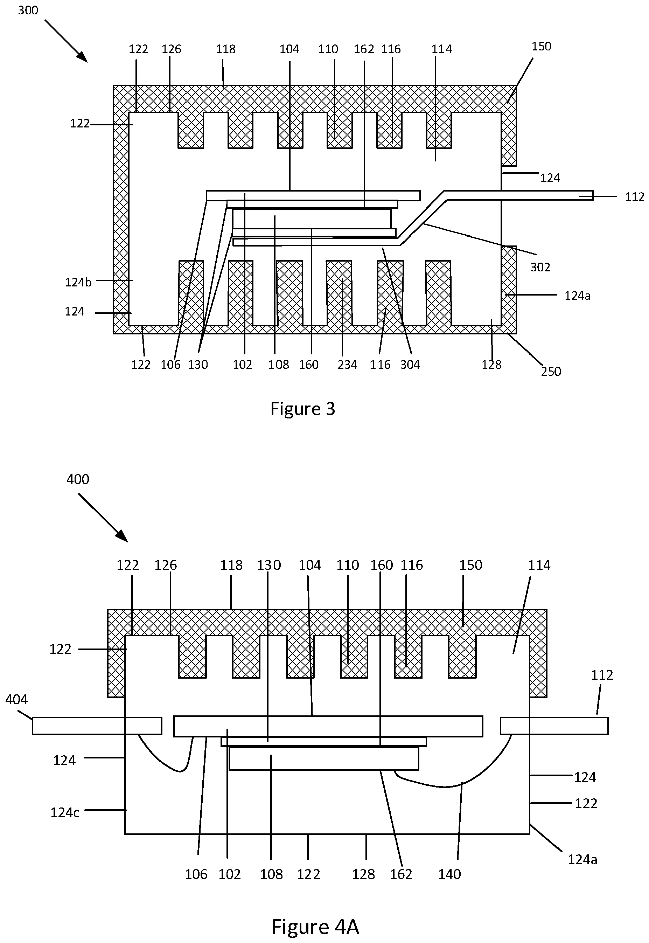

Figure 1 shows a cross-section of a semiconductor package 100 comprising a semiconductor die 108 having a top side 160 and a bottom side 162 opposite to the top side 160. The bottom side 162 of the semiconductor die 108 is mounted on a first surface 106 of a substrate 102 by an interconnection 130, e.g., but not limited to a sintered, soldered, or welded interconnection. The substrate 102 comprises a second surface 104 opposite to the first surface 106. The top side 160 of the semiconductor die 108 is electrically connected to an external terminal 112, e.g., but not limited to via bond wires or ribbons 140, or a clip (not shown in Figure 1 bit indicated in Figure 3 and described in connection with Figure 3 herein below). The substrate 102 is electrically connected to a further external terminal (not shown in Figure 1) laterally adjacent to the external terminal 112. In some examples, the substrate 102 may be monolithically formed with the further external terminal e.g., as part of a contiguous leadframe. An encapsulation 114 fully encapsulates the semiconductor die 108 and the substrate 102 providing electrical insulation. All external terminals are partially exposed from the encapsulation 114 providing electrical connection with e.g., a printed circuit board, a busbar etc.

An outer surface 122 of the encapsulation 114 comprises recesses 110 with a certain depth and a lateral expansion. The depth of the recesses 110 is measured orthogonal to the outer surface 122 of the encapsulation 114.The depth of the respective recesses may be the same (as shown in Figure 1) or varying (as describe in more detail in the following). A material 116 with thermal conductivity higher than that of the encapsulation 114 is inserted into the recesses 110 and fills up the recesses 110. The material 116 may comprise or consist of a metal such as but not limited to silver, copper or aluminum.

Optionally, the material 116 may exceed the depth of the recesses 110 forming a contiguous layer 150 on the outer surface 122 of the encapsulation 114 and interconnecting the recesses 110.

With the material 116 of large thermal conductivity protruding into the encapsulation 114, heat from the core of the semiconductor package 100 can be conducted to the outside more easily, allowing an improved thermal performance of the semiconductor package 100.

The material 116 can be disposed over the outer surface 122 of the encapsulation 114 filling the recesses 110 and/or forming the contiguous layer 150 using methods such as but not limited to pulsed laser deposition, aerosol jet printing, cold spray coating, printing (stencil, screen, impulse printing etc.) with or without transparent carrier, plateable mold compound, electrochemical deposition, electroless seed layer (Pd activated surface).

The contiguous layer 150 has a main surface 118 facing the outer surface 122 of the encapsulation 114. The main surface 118 of the contiguous layer 150 may be a patterned surface or a plane surface. An external heat sink may be mounted on the main surface 118 of the contiguous layer by methods such as but not limited to welding, soldering, or sintering, thermally conductive adhesives, etc. Alternatively, a thickness of the contiguous layer 150 in a direction orthogonal to the first side 126 of the outer surface 122 of the encapsulation 114 can be chosen such that the contiguous layer 150 buffers a required amount of heat.

Instead of or in addition to the heat sink, a cooler may be mounted on the main surface 118 of the contiguous layer 150. The main surface 118 of the contiguous layer 150 may form a wall of the cooler, wherein the main surface 118 of the contiguous layer 150 may be in direct contact with a coolant flowing inside the cooler.

The encapsulation 114 which is usually a resin or epoxy material has a lower thermal conductivity as compared to the material 116. Typical epoxy encapsulations have a thermal conductivity of less than 1W/mK, wherein metals such as silver, copper or aluminum have a thermal conductivity in the range of 300-450W/mK. The recesses 110 filled with the material 116 can be positioned close to the substrate 102, the semiconductor die 108 and/or bond wires or ribbons 140 to more effectively dissipate the heat. The lateral width and the depth of the recesses 110 can be chosen in a flexible manner depending on the heat generation inside the package 100 to optimize the heat transfer while maintaining the electrical insulation of the material 116. This makes the concept especially suitable for semiconductor package scaling and/or integrated packages in which more functionalities are integrated in the same package, such that efficient heat dissipation may increase the performance of the semiconductor packages. This concept can be used for semiconductor packages comprising a single semiconductor die or multiple semiconductor dies mounted on the same or multiple substrates, in which multiple semiconductor dies are arranged above or lateral to each other within the semiconductor package.

The outer surface 122 of the encapsulation 114 comprises a first side 126, a second side 128 opposite the first side 126, and side walls 124 connecting the first 126 and the second side 128. In the example shown in Figure 1, the first side 126 of the encapsulation 114 faces the second surface 104 of the substrate 102. and all the external terminals are protruding out from a single 124aside of the outer surface 122 of the encapsulation 114.

In the semiconductor package 100 shown in Fig. 1, the recesses 110 are formed on the first side 126 of the outer surface 122 of the encapsulation 114 facing the second surface 104 of the substrate 102 while maintaining electrical insulation from the substrate 102.

Figure 2 shows a cross-sectional view of a semiconductor package 200 which is similar to the semiconductor package 100 and will only be described with regard to the differences from the semiconductor package 100 in the following. The contiguous layer 150 extends on the first 124a and a second side 124b of the outer surface 122 of the encapsulation 114. The first side 124a of the outer surface 122 of the encapsulation 114 is only partially covered by the contiguous layer 150 keeping the required distances from all the external terminals 112 with regard to electrical insulation.

The semiconductor package 200 shown in Figure 2 has further recesses 234 on the second side 128 of the outer surface 122 of the encapsulation 114 facing the semiconductor die 108 and/or the bond wires or ribbons 140. The recesses 234 may have a different depth and a width as compared with the recesses 110.

The recesses 234 are also filled with the material 116 as described in the previous examples. The depth and the width of the recesses 234 is again such that the material 116 is electrically insulated from the semiconductor die 108 and bond wires or ribbons 140.

The material 116 may exceed the depth of the recesses 234 forming a contiguous layer 250 on the second side 128 of the outer surface 122 of the encapsulation 114. The contiguous layer 250 may be extended to the first 124a and the second side 124b of the side wall 124 of the outer surface 122 of the encapsulation 114 similar to the contiguous layer 150 of the semiconductor package 100 of Figure 1. In some examples, the contiguous layers 150 and 250 may join on the second side 124b of the side wall 124 of the outer surface 122 of the encapsulation 114.

Optionally, the semiconductor package 200 may have recesses 244 similar to the recesses 234 but the recesses 244 may have a different depth and/or lateral expansion as compared to the recesses 234 and/or the recesses 110.

With the varying depth of the recesses 234 and 244 height differences of the internal package components, e.g., between the bond wires or ribbons 140 and the top side 160 of the semiconductor die 108 can be accounted for, in order to maximize thermal conductivity while maintaining electrical isolation between the components and the material 116.

Figure 3 shows a cross-sectional view of a semiconductor package 300, wherein the semiconductor package 300 is similar to the semiconductor package 200 of Figure 2 and will be described only with regard to the differences to Figure 2 in the following.. Instead of bond wires or ribbons connection between the semiconductor die 108 chip and the external terminal 112, a clip 302 provides the connection. A section 304 of the clip 302 covers and is electrically connected with the top side 160 of the semiconductor die 108 via the interconnection 130. The clip 302 may be integrally formed with the external 112, or it may be formed separately from and connected to the external terminal 112 by soldering, sintering, or other suitable methods. Due to a uniform distance between the section 304 of the clip 302 and the second side 128 of the outer surface 128 of the encapsulation 114, recesses 234 with the uniform depth can be formed.

The contiguous layers 150 and 250 are exemplary shown as joint in this embodiment at the second side 124b of the side wall 124 of the outer surface 122 of the encapsulation 114.

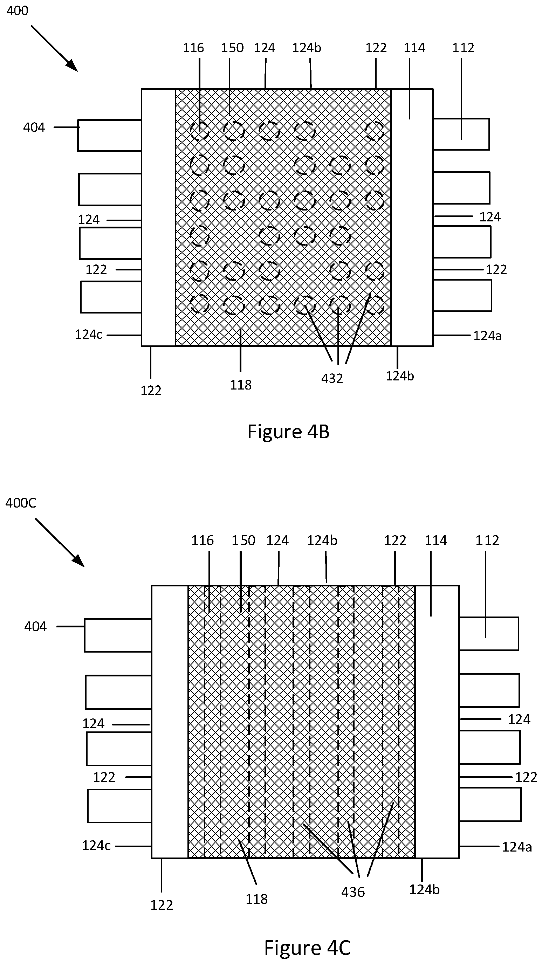

Figure 4A shows a cross-sectional view of the semiconductor package 400, wherein the semiconductor package 400 is similar to the semiconductor package 100 of Figure 1 and will be described only with regard to the differences to Figure 1 in the following. Wherein the examples shown in Figures 1-3 have outer leads only on one side of the side wall 124 of the encapsulation, e.g., for instance as in TO-like semiconductor packages, the example in Figure 4 comprises external terminals protruding out from both opposing sides 124a and 124c of the side wall 124 of the outer surface 122 of the encapsulation 114 such as but not limited to DSO-like semiconductor packages. For example, the external terminal 112 may be electrically connected to the top side 160 of the semiconductor die 108 via bond wires or ribbons 140 or a clip as shown in the previous examples. A further external terminal 404 protruding from the opposite side of the external terminal 112 is electrically connected to substrate 102 via bond wires or ribbons 140, clips or a monolithically formed connection.

Figure 4B shows a top view of the semiconductor package 400 of Figure 4A. As shown the recesses are formed as a plurality of vias 432 with a limited lateral dimension, e.g., circular or squared. The plurality of vias 432 may be distributed across the first side 126 of the outer surface 122 of the encapsulation 114 uniformly or non-uniformly. The number of vias formed close to a part of the substrate comprising the semiconductor die 108 may be increased with regard to the periphery. Each via in the plurality of vias 432 may have a different depth and/or lateral expansion from the neighboring via. The contiguous layer 150, interconnects each via in the plurality of vias 432. As discussed in the previous examples, the second side 128 of the outer surface 122 of the encapsulation 114 may also have a plurality of vias similar to the plurality of vias 432.

Figure 4C shows a top view of a semiconductor package 400C which is an alternative example of the semiconductor package 400 of Figure 4. The recesses are formed as a plurality of trenches 436 in a uniform manner on first side 126 of the outer surface 122 of the encapsulation 114. Each trench in the plurality of trenches 436 may have a different depth and lateral expansion from neighboring trenches and is interconnected with the neighboring trenches with the contiguous layer 150. Optionally, the number of trenches close to a part of the substrate 102 comprising the semiconductor die 108 may be increased with regard to the periphery. As discussed in the previous examples, the second side 128 of the outer surface 122 of the encapsulation 114 may also have another plurality of trenches similar to the plurality of trenches 436.

The plurality of vias 432 and the plurality of trenches 436 shown in Fig 4B and 4C respectively can be formed by but not limited to e.g., a cavity in the mold tool, dicing or laser dicing.

Wherein all examples described herein above have been shown with a certain number of recesses the skilled artesian will recognize that one or any suitable number of recesses could be implemented.

The semiconductor die may, for example, be configured as power MISFETs (Metal Insulator Semiconductor Field Effect Transistors), power MOSFETs (Metal Oxide Semiconductor Field Effect Transistors), IGBTs (Insulated Gate Bipolar Transistors), JFETs (Junction Gate Field Effect Transistors), HEMTs (High Electron Mobility Transistors), power bipolar transistors or power diodes such as, e.g., PIN diodes or Schottky diodes.

The semiconductor die may be manufactured from specific semiconductor material such as, for example, Si, SiC, SiGe, GaAs, GaN, AlGaN, InGaAs, InAIAs, etc., and, furthermore, may contain inorganic and/or organic materials that are not semiconductors. The semiconductor die may be of different types and may be manufactured by different technologies.

The semiconductor package described herein includes a substrate. The substrate may form a part of a structured metal sheet such as, e.g., a leadframe. The substrate, the semiconductor die and the external terminal may at least partly be surrounded or embedded in an encapsulant. The encapsulant may form part of the periphery of the semiconductor package, i.e., may at least partly define the shape of the semiconductor package.

The encapsulant may be an electrically insulating material and may comprise or be a thermoset material or a thermoplastic material. A thermoset material may, e.g., be made on the basis of an epoxy resin, a silicone resin or an acrylic resin. A thermoplastic material may, e.g., comprise one or more materials selected from the group of polyetherimide (PEI), polyether-sulfone (PES), polyphenylene-sulfide (PPS), polyamide-imide (PAI), and polyethylene-terephthalate (PET). Thermoplastic materials melt by application of pressure and heat during molding or lamination and (reversibly) harden upon cooling and pressure release.

The encapsulant may include or be a polymer material, e.g., a duroplastic polymer material. The encapsulant may include or be at least one of a filled or unfilled mold material, a filled or unfilled thermoplastic material, a filled or unfilled thermoset material, a filled or unfilled laminate, a fiber-reinforced laminate, a fiber-reinforced polymer laminate, and a fiber-reinforced polymer laminate with filler particles.

In particular, the encapsulant may be a mold material. The encapsulant may then be applied over the semiconductor die and the substrate. Various techniques such as, e.g., compression molding, injection molding, powder molding, liquid molding, transfer molding or film-assisted molding (FAM) may be used to form the encapsulant.

A variety of different types of electronic devices may be configured to use a semiconductor package as described herein. By way of example, an electronic device in accordance with the disclosure may constitute, e.g., an engine control unit (ECU), a power supply, a DC-DC voltage converter, an AC-DC voltage converter, a power amplifier, and many other devices, in particular power devices.

The following examples pertain to further aspects of the disclosure:
Example 1 discloses a semiconductor package comprising:
   - a substrate,
   - a semiconductor die mounted to a first surface of the substrate,
   - an encapsulation at least partially encapsulating the semiconductor die and the substrate, wherein the encapsulation comprises a recess at an outer surface of the encapsulation,
   - a material disposed filling up the recess,
   - wherein the material has a higher thermal conductivity than the encapsulation,
   - wherein the material is electrically isolated from the substrate and the semiconductor die.
Example 2 discloses the semiconductor package according to example 1, wherein the material exceeds the recesses forming a contiguous layer on the outer surface of the encapsulation and interconnecting the recesses.
Example 3 discloses the semiconductor package according to example 2, wherein the substrate comprises a second surface opposite the first surface and the recess comprises a first recess on a first side of the outer surface of the encapsulation, wherein the first side faces the second surface of the substrate.
Example 4 discloses the semiconductor package according to example 3, wherein the contiguous layer partially or fully covers the first side and a side wall of the outer surface of the encapsulation, wherein the side wall connects the first side of the outer surface of the encapsulation with a second side of the outer surface of the encapsulation opposite the first side.
Example 5 discloses the semiconductor package according to example 4, wherein the semiconductor package further comprises a second recess at an outer surface of the encapsulation.
Example 6 discloses the semiconductor package according to example 5, wherein the first recess and the second recess have a uniform depth or a varying depth.
Example 7 discloses the semiconductor package according to example 5, wherein the second recess is on a second side of the outer surface of the encapsulation.
Example 8 discloses the semiconductor package according to example 7, wherein the semiconductor package comprises a third recess on the second side of the outer surface of the encapsulation, wherein the second recess and the third recess have a uniform depth or a varying depth.
Example 9 discloses the semiconductor package according to example 8, wherein the second recess and the third recess are interconnected by the contiguous layer on the second side of the outer surface of the encapsulation.
Example 10 discloses the semiconductor package according to any preceding example, wherein an external terminal protrudes from the side wall of encapsulation and the external terminal is electrically coupled with the semiconductor die, wherein the external terminal is partially encapsulated by the encapsulation and electrically isolated from the material.
Example 11 discloses the semiconductor package according to any preceding example, wherein a main surface of the contiguous layer is adapted to be mountable to a heat sink via welding, soldering, sintering or a thermally conductive adhesive, wherein the main surface faces away from the recess.
Example 12 discloses the semiconductor package according to any preceding example, wherein the recess is in the form of vias restricted in a lateral direction or trenches extending along the side walls of the outer surface.
Example 13 discloses the semiconductor package according to any preceding example, wherein the material layer is a metal, in particular silver, copper or aluminum.
Example 14 discloses a method for producing a semiconductor package, wherein the method comprises:
   - providing a substrate,
   - mounting a semiconductor die to a first surface of the substrate,
   - at least partially encapsulating the semiconductor die and the substrate by an encapsulation,
   - providing a recess at an outer surface of the encapsulation,
   - disposing a material filling up the recess,
   - wherein the material has a higher thermal conductivity than the encapsulation,
   - wherein the material is electrically isolated from the substrate and the semiconductor die.
Example 15 discloses the method for producing a semiconductor package according to example 14, wherein the material exceeds the recesses forming a contiguous layer on the outer surface of the encapsulation and interconnecting the recesses.
Example 16 discloses the method for producing a semiconductor package according to example 15, wherein the recess is formed by cavity in mold tool, dicing or laser dicing.
Example 17 discloses the method for producing a semiconductor package according to example 15, wherein disposing the layer is done by one of pulsed laser deposition, aerosol jet printing, cold spray coating, printing (stencil, screen, impulse printing etc.) with or without transparent carrier, plateable mold compound, electrochemical deposition, electroless seed layer (Pd activated surface).

## Claims

1. A semiconductor package (100, 200, 300, 400, 400D) comprising:
- a substrate (102),
- a semiconductor die (108) mounted to a first surface (106) of the substrate (102),
- an encapsulation (114) at least partially encapsulating the semiconductor die (108) and the substrate (102), wherein the encapsulation (114) comprises a recess (110) at an outer surface (122) of the encapsulation (114),
- a material (116) filling up the recess (110),
- wherein the material (116) has a higher thermal conductivity than the encapsulation (114),
- wherein the material (116) is electrically isolated from the substrate (102) and the semiconductor die (108).

2. A semiconductor package (100, 200, 300, 400, 400D) according to claim 1, wherein the material (116) exceeds the recesses (110) forming a contiguous layer (150) on the outer surface (122) of the encapsulation (114) and interconnecting the recesses (110).

3. The semiconductor package (100) according to claim 2, wherein the substrate (102) comprises a second surface (104) opposite the first surface (106) and the recess (110) comprises a first recess (134) on a first side (126) of the outer surface (122) of the encapsulation (114), wherein the first side (126) faces the second surface (104) of the substrate (102).

4. The semiconductor package (100, 200, 300, 400, 400D) according to claim 3, wherein the contiguous layer (150) partially or fully covers the first side (126) and a side wall (124) of the outer surface (122) of the encapsulation (114), wherein the side wall (124) connects the first side (126) of the outer surface (122) of the encapsulation (114) with a second side (128) of the outer surface (122) of the encapsulation (114) opposite the first side (126).

5. The semiconductor package (100, 200, 300, 400, 400D) according to claim 4, wherein the semiconductor package (100, 200, 300, 400, 400D) further comprises a second recess (234) at an outer surface (122) of the encapsulation (114).

6. The semiconductor package (100, 200, 300, 400, 400D) according to claim 5, wherein the first recess (134) and the second recess (234) have a uniform depth or a varying depth.

7. The semiconductor package (200, 300, 400, 400D) according to claim 5, wherein the second recess (234) is on the second side (128) of the outer surface (122) of the encapsulation (114).

8. The semiconductor package (200, 300, 400, 400D) according to claim 7, wherein the semiconductor package (200, 300, 400, 400D) comprises a third recess (244) on the second side (128) of the outer surface (122) of the encapsulation (114), wherein the second recess (234) and the third recess (244) have a uniform depth or a varying depth.

9. The semiconductor package (200, 300) according to claim 8, wherein the second recess (234) and the third recess (244) are interconnected by the contiguous layer (250) on the second side (128) of the outer surface (122) of the encapsulation (114).

10. The semiconductor package according to any preceding claims, wherein an external terminal (112) protrudes from the side wall (124) of encapsulation (114) and the external terminal (112) is electrically coupled with the semiconductor die (108), wherein the external terminal (112) is partially encapsulated by the encapsulation (114) and electrically isolated from the material (116).

11. The semiconductor package according to any preceding claim, wherein a main surface (118) of the contiguous layer (150) is adapted to be mountable to a heat sink via welding, soldering, sintering or a thermally conductive adhesive, wherein the main surface (118) faces away from the recess (110).

12. The semiconductor package according to any preceding claim, wherein the recess (110) is in the form of vias formed locally or trenches.

13. The semiconductor package according to any preceding claim, wherein the material (116) is a metal layer in particular silver, copper or aluminum.

14. A method for producing a semiconductor package (100, 200, 300, 400, 400D), wherein the method comprises:
providing a substrate (102),
mounting a semiconductor die (108) mounted to a first surface (106) of the substrate (102),
at least partially encapsulating the semiconductor die (108) and the substrate (102) by an encapsulation (114),
providing a recess (110) at an outer surface (122) of the encapsulation (114),
disposing a material (116) filling up the recesses (110),
wherein the material (116) has a higher thermal conductivity than the encapsulation (114),
wherein the material (116) is electrically isolated from the substrate (102) and the semiconductor die (108).

15. The method for producing a semiconductor package (100, 200, 300, 400, 400D) according to claim 14, wherein the material (116) exceeds the recesses (110) forming a contiguous layer (150) on the outer surface (122) of the encapsulation (114) and interconnecting the recesses (110).

16. The method for producing a semiconductor package (100, 200, 300, 400, 400D) according to claim 15, wherein the recess (110) is formed by cavity in mold tool, dicing or laser dicing.

17. The method for producing a semiconductor package (100, 200, 300, 400, 400D) according to claim 15, wherein disposing the material (116) is done by one of pulsed laser deposition, aerosol jet printing, cold spray coating, printing (stencil, screen, impulse printing etc.) with or without transparent carrier, plateable mold compound , electrochemical deposition, electroless seed layer (Pd activated surface).
